Europäisches Patentamt

European Patent Office

Office européen des brevets

(19)

(11) Veröffentlichungsnummer: **0 024 556**
**B1**

(12) **EUROPÄISCHE PATENTSCHRIFT**

(45) Veröffentlichungstag der Patentschrift:
06.04.83

(51) Int. Cl.³: **G 01 R 27/18,** H 02 H 3/16

(21) Anmeldenummer: 80104439.7

(22) Anmeldetag: 28.07.80

(54) Überwachungseinrichtung für den Isolationswiderstand des Serienstromkreises einer Flugplatzbefeuerungsanlage.

(30) Priorität: 02.08.79 DE 2931445

(43) Veröffentlichungstag der Anmeldung:
11.03.81 Patentblatt 81/10

(45) Bekanntmachung des Hinweises auf die Patenterteilung:
06.04.83 Patentblatt 83/14

(84) Benannte Vertragsstaaten:
BE FR GB NL

(56) Entgegenhaltungen:
DE-B-7 965
DE-B-1 139 577

(73) Patentinhaber: SIEMENS AKTIENGESELLSCHAFT,
Berlin und München Wittelsbacherplatz 2,
D-8000 München 2 (DE)

(72) Erfinder: Vellage, Karl-Heinz, Schobertweg 34 1/2,
D-8520 Erlangen (DE)
Erfinder: Friesleben, Klaus, Am Schellenberg 13,
D-8550 Forchheim (DE)

## Überwachungseinrichtung für den Isolationswiderstand des Serienstromkreises einer Flugplatzbefeuerungsanlage

Die Erfindung betrifft eine Überwachungseinrichtung gemäss Oberbegriff von Anspruch 1.

Eine dauernde Überwachung derartiger Anlagen ist erforderlich, um bereits den ersten auftretenden Isolationsfehler umgehend beseitigen zu können. Nur dann ist nämlich gewährleistet, dass der Isolationswiderstand im Laufe der Zeit aufgrund der Wärmeleistung des Fehlerstromes nicht unzulässig abnimmt. Auch ist die Ortung eines einzigen Isolationsfehlers wesentlich einfacher als die mehrerer Isolationsfehler.

Da somit der Isolationswiderstand während der gesamten Betriebszeit des Serienstromkreises überwacht werden muss, hat man bereits bei bekannten Geräten von der den Serienstromkreis speisenden Spannung eine Gleichspannung abgeleitet und diese über ein Relais zwischen dem Leiter des Kabels und einem diesen umgebenden Schirm angelegt; der eine Anschluss des Relais liegt dabei an dem Schirm und der andere ist über je einen Widerstand und eine Gleichrichterdiode mit jedem der beiden Enden des Kabels verbunden.

Bei dieser bekannten Schaltung ist jedoch der durch das Relais fliessende Strom nicht nur von der Grösse des Isolationswiderstandes sondern zusätzlich von der Höhe der augenblicklichen Betriebsspannung des Serienstromkreises und insbesondere auch von der Lage des Fehlerortes im Serienstromkreis abhängig: Eine eindeutige Messung des Isolationswiderstandes und somit eine Meldung beim Unterschreiten eines bestimmten Grenzwertes ist hier nicht möglich.

Aus der DE-AS-1 271 824 ist es andererseits bekannt, zur Überwachung des Isolationswiderstandes in einem Wechselspannungsnetz mit höherer Spannung eine Hilfsgleichspannung zu verwenden und den Messstromkreis mit Hilfe einer Sperrdrossel von dem Wechselspannungsnetz zu entkoppeln. Der Messgleichstrom erzeugt jedoch hierbei in der Sperrdrossel eine Gleichstromvormagnetisierung, die zu einer Reduzierung der wirksamen Induktivität mit der Folge eines höheren und zudem noch unsymmetrischen Magnetisierungswechselstromes führt, der die Isolationswiderstandsmessung verfälscht.

Der Erfindung liegt daher die Aufgabe zugrunde, diesen Einfluss bei einer Überwachungseinrichtung gemäss Oberbegriff des Anspruches 1 so klein wie möglich zu halten, ohne eine kostspielig grosse Drossel verwenden zu müssen.

Die erfindungsgemässe Lösung dieser Aufgabe ist durch die Merkmale des Anspruches 1 gekennzeichnet. Bei der Erfindung wird somit die vom Messgleichstrom herrührende Vormagnetisierung durch eine entsprechend grosse Gegenmagnetisierung aufgehoben.

Als zusätzliche Massnahme ist es zweckmässig, den Messstromkreis so zu dimensionieren, dass der bei dem kleinsten messbaren Isolationswiderstand auftretende Messgleichstrom nur eine vernachlässigbar kleine Gleichstrommagnetisierung der Drossel bewirkt. Bei Verwendung des Gleichstromrelais als Grenzwertgeber ist es daher vorteilhaft, die Erregerwicklung dieses Relais an den Ausgang eines Verstärkers, beispielsweise eines Transistors, anzuschalten, dem eingangsseitig der Spannungsabfall an einèm im Messstromkreis liegenden Widerstand zugeführt wird. Diese Schaltung hat zugleich den Vorteil, dass sich ein verhältnismässig hoher Isolationswiderstand als Ansprechgrenzwert einstellen lässt.

Ein Ausführungsbeispiel wird anhand der Figuren näher erläutert, von denen

Fig. 1 das Ersatzschaltbild eines Serienstromkreises und

Fig. 2 den Aufbau einer erfindungsgemässen Überwachungseinrichtung zeigen.

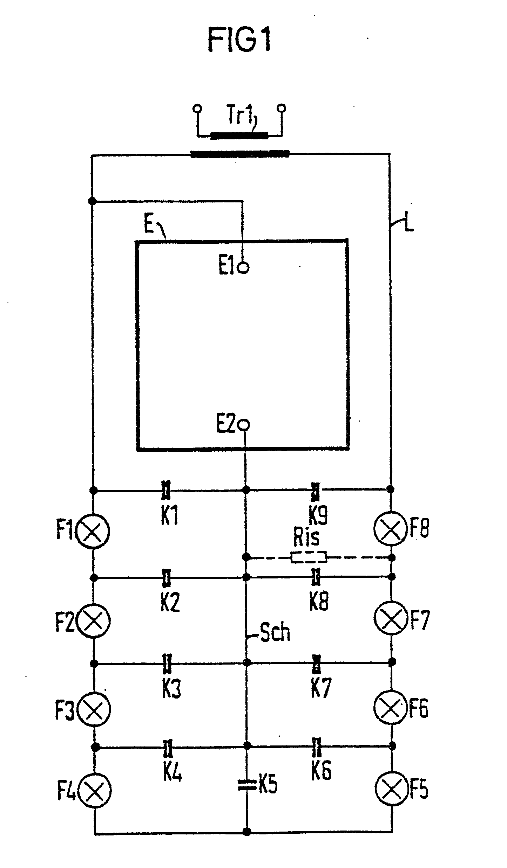

In Fig. 1 ist ein Serienstromkreis mit nur acht Unterflurfeuern F1 bis F8 dargestellt, die untereinander durch etwa gleichlange Kabelabschnitte verbunden und an die Sekundärwicklung des Speisetransformators Tr1 angeschlossen sind; in der Praxis liegen bis zu 100 Unterflurfeuer in Reihe, so dass die Speisewechselspannung bis zu 5 kV betragen kann. Das Kabel besteht aus einem Leiter L, der konzentrisch von einem Schirm Sch umgeben ist; dementsprechend sind die Kapazitäten zwischen dem Leiter der einzelnen Kabelabschnitte und dem Schirm als Kondensatoren K1 bis K9 eingezeichnet. Ferner ist punktiert der Widerstand $R_{is}$ eines Isolationsfehlers eingezeichnet. Die Überwachungseinrichtung selbst ist in Fig. 1 lediglich als Zweipol E mit den Klemmen E1 und E2 angegeben und zwischen dem einen Ende des Kabels und dessen Schirm angeschlossen.

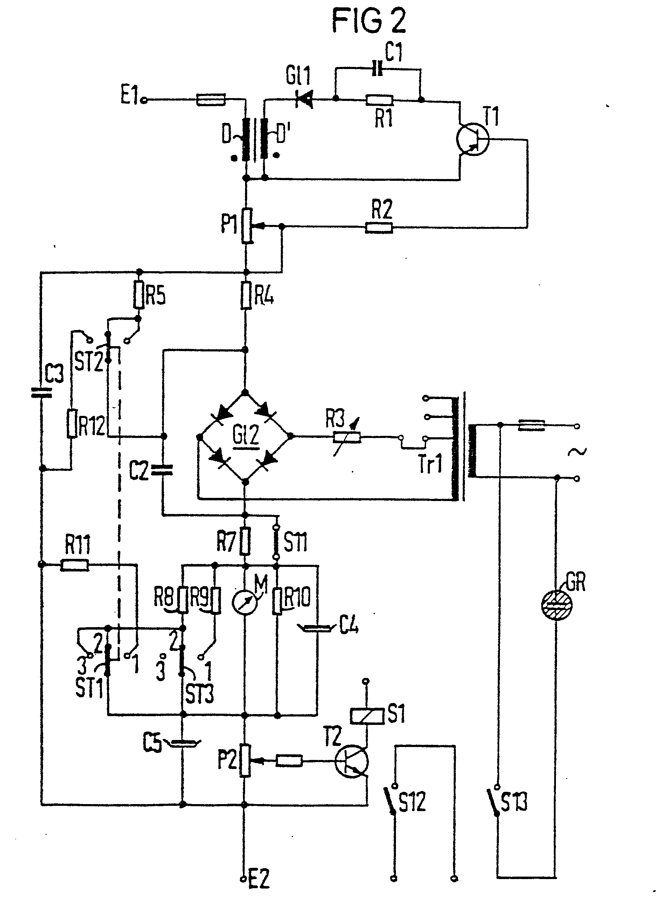

Die Überwachungseinrichtung E ist in Fig. 2 dargestellt und besteht im wesentlichen aus einem Messstromkreis zwischen den Klemmen E1 und E2, in dem in Reihenschaltung hintereinander eine Sperrdrossel D, ein Einstellwiderstand P1, ein Kopplungswiderstand R4, ein Brückengleichrichter Gl2, ein Widerstand R7, ein Messinstrument M und ein Stellwiderstand P2 angeordnet sind. An letzterem ist die Steuerstrecke eines Transistors T2 angeschlossen, in dessen Emitterkollektorkreis die Erregerwicklung eines Gleichstromrelais S1 mit den Arbeitskontakten S12, S13 und einem Ruhekontakt S11 liegt. Dieses Relais bildet zusammen mit dem Transistor und dem Stellwiderstand P2 einen Grenzwertgeber, der bei einem an P2 einstellbaren Wert des Messgleichstromes anspricht.

Die Messgleichspannung liefert die Gleichrichterbrücke Gl2, die hierzu über den Widerstand R3 und einen Transformator Tr1 aus einer Wechselspannungsquelle gespeist wird.

Die Drossel D hat eine Sekundärwicklung D', die einen Gegenmagnetisierungskreis mit einem steuerbaren Widerstand in Form der Emitterkollektorstrecke eines Transistors T1 speist, die zugleich als Ventil wirkt; zum Schutz vor unzulässig hoher. Spannung ist jedoch noch ein zusätzliches Ventil Gl1 vorgesehen. Ferner enthält der Gegenmagnetisierungskreis einen Widerstand R1 mit parallel geschaltetem Kondensator C1, durch den die Phasenverschiebung zwischen Strom und Spannung in dem Gegenmagnetisierungskreis verkleinert wird. Die Steuerstrecke des Transistors T1 ist über einen Widerstand R2 an einen veränderbaren Teil des Einstellwiderstandes P1 angeschlossen: Auf diese Weise ergibt sich während der positiven Halbwellen der Speisewechselspannung bei der dargestellten Polung des Gleichrichters GI2 ein Magnetisierungsstrom, der der vom Messgleichstrom hervorgerufenen Vormagnetisierung entgegenwirkt; seine Grösse ist von der des Stromes im Messstromkreis abhängig, so dass eine Arbeitspunktverschiebung durch den Gegenmagnetisierungskreis ohne entsprechende Vormagnetisierung durch den Messstromkreis vermieden wird. Durch entsprechende Bemessung und Einstellung lässt sich erreichen, dass die positive und negative Amplitude des von der Speisewechselspannung hervorgerufenen Magnetisierungsstromes der Drossel gleich gross sind, die Speisewechselspannung also keine das Messergebnis verfälschende Gleichstromkomponente verursacht.

Mit Hilfe eines zweibahnigen Umschalters ST1, 2 mit den drei Schaltstellungen 1, 2, 3 lassen sich drei Funktionsweisen einstellen: Die Stellung 1 dient zur Messung des Isolationswiderstandes, beispielsweise zwischen 1 und 100 MΩ. Die Schaltstellung 2 (Melden) ermöglicht die dauernde Überwachung und Meldung bei Unterschreiten eines bestimmten Isolationswiderstandsgrenzwertes. Die Schaltstellung 3 (Prüfen) dient schliesslich der Überprüfung des Gerätes auf Funktionsfähigkeit sowie der Eichung. In dieser Schaltstellung ist der Messkreis durch den Entkopplungswiderstand R4 von etwa 5 MΩ von dem zu überwachenden Serienstromkreis praktisch abgetrennt. Die Spannung des Gleichrichters GI2 liegt über den Widerstand P12 an dem Messkreis. Der Wert dieses Widerstandes, der einen Isolationswiderstand des zu überwachenden Kabels simuliert, richtet sich nach dem gewünschten Ansprechwert und kann dementsprechend veränderbar sein.

In der Schaltstellung 3 (Prüfen) wird der Widerstand von P2 so weit erhöht, bis das Relais S1 gerade anzieht und die zugeordneten Kontakte S11 bis S13 betätigt werden: S13 schaltet eine Meldeleuchte GR im Gerät selbst und S12 einen Fernmeldestromkreis ein. S11 schliesslich schaltet den Widerstand R7 in den Messkreis. Dieser ist so gross bemessen, dass der dann über ihn fliessende Messgleichstrom nur geringfügig über dem Haltestrom des Relais liegt, wodurch sich eine entsprechende Entlastung der Drossel D bis zur Beseitigung des Isolationsfehlers ergibt. In der Stellung 1 (Messen) ist der Stellwiderstand P2 durch einen Widerstand R11 überbrückt, der so bemessen ist, dass das Relais S1 abfällt und R7 durch S11 überbrückt ist: Der Innenwiderstand $R_i$ ist somit im wesentlichen durch R11, P2 und R5 bestimmt. Durch Verändern des Widerstandes R3 und der Anzapfungen des Transformators Tr1 wird schliesslich der Messstromkreis geeicht, d.h. ein definierter Strom am Messinstrument M eingestellt, der der Spannung $U_G$ in der nachstehenden Formel proportional ist:

$$R_{is} = \frac{U_G}{I_G} - R_i$$

Die Widerstände R8 bis R10 dienen zusammen mit einem Umschalter ST3 zur Einstellung unterschiedlicher Messbereiche des Messinstrumentes M, das entweder direkt den Isolationswiderstand oder den Messgleichstrom anzeigt; in letzterem Falle errechnet sich der Isolationswiderstand nach der angegebenen Formel, wobei $U_G$ die Spannung an dem Gleichrichter GI2 und $R_i$ der Innenwiderstand des Messstromkreises zwischen den Klemmen E1, E2 bedeuten.

Die Kondensatoren C2, C3, C4 und C5 leiten eventuelle Wechselspannungskomponenten an dem eigentlichen Messzweig vorbei, was zu einer weiteren Steigerung der Messgenauigkeit beiträgt.

## Patentansprüche

1. Überwachungseinrichtung für den Isolationswiderstand des Serienstromkreises einer Flugplatzbefeuerungsanlage, bei der die einzelnen Flugplatzfeuer miteinander und der Wechselspannungsquelle durch Abschnitte eines Kabels verbunden sind, mit einem zwischen einem Ende des Leiters des Kabels und einem dagegen isolierten Bezugspunkt anzuschliessenden Messstromkreis, der eine Gleichspannungsquelle, eine Sperrdrossel und einen auf den Messgleichstrom ansprechenden Grenzwertgeber in Reihenschaltung enthält, dadurch gekennzeichnet, dass die Sperrdrossel (D) eine Sekundärwicklung (D') aufweist, die einen Gegenmagnetisierungskreis mit einem steuerbaren Widerstand (T1) speist, dass dieser steuerbare Widerstand vom Strom des Messstromkreises derart abhängig ist, dass der Widerstand bei steigendem Strom im Messstromkreis fällt, und dass der Gegenmagnetisierungskreis ein Ventil (GI1) enthält, das so gepolt ist, dass der in dem Gegenmagnetisierungskreis fliessende Strom der Vormagnetisierung der Sperrdrossel (D) durch den Messgleichstrom entgegenwirkt.

2. Überwachungseinrichtung nach Anspruch 1, dadurch gekennzeichnet, dass die Erregerwicklung des Gleichstromrelais (S1) im Ausgangskreis eines Verstärkers liegt, dem eingangsseitig ein dem Strom im Messstromkreis proportionales Signal zugeführt wird.

3. Überwachungseinrichtung nach Anspruch 1 oder 2, mit einem Messinstrument zur Anzeige des Fehlerstromes oder des Isolationswiderstandes im Messstromkreis, dadurch gekennzeichnet, dass in dem Messstromkreis ein Zusatzwiderstand (R7) liegt, der von einem Ruhekontakt (S11) des Gleichstromrelais (S1) überbrückt ist und dass dem Grenzwertgeber ein Widerstand (R11) parallelschaltbar ist, der so bemessen ist, dass der Grenzwertgeber bei parallelgeschaltetem Widerstand abfällt.

## Claims

1. A monitoring device for the insulation resistance of the series circuit of an airport lighting system, wherein the individual airport lights are connected to one another and to the alternating voltage source by means of sections of a cable, comprising a measuring circuit which is to be connected between an end of the conductor of the cable and a reference point insulated against the latter and which comprises in series connection a direct voltage source, a suppression choke and a limit value generator, which responds to the measuring direct current, characterised in that the suppression choke (D) has a secondary winding (D') which feeds an opposing magnetization circuit with a controllable resistance (T1), and that this controllable resistance is dependent upon the current of the measuring circuit in such manner that when the current in the measuring circuit increases, the resistance drops, and that the opposing magnetization circuit comprises a valve (Gl1) which is poled in such manner that the current flowing in the opposing magnetization circuit counteracts the premagnetization of the suppression choke (D) by means of the measuring direct current.

2. A monitoring device as claimed in Claim 1, characterised in that the excitation winding of the direct current relay (S1) lies in the output circuit of an amplifier which is fed with a signal proportional to the current in the measuring circuit at the input end.

3. A monitoring device as claimed in Claim 1 or 2, comprising a measuring instrument which serves to display the fault current or the insulation resistance in the measuring circuit, characterised in that in the measuring circuit is arranged an additional resistor (R7) which is bridged by a rest contact (S11) of the direct current relay (S1), and there can be connected parallel to the limit value generator a resistor (R11) so contrived that the limit value generator drops when the resistor is connected in parallel.

## Revendications

1. Dispositif de surveillance de la résistance d'isolement du circuit série d'une installation de balisage d'un aérodrome, dans lequel les balises individuelles sont reliées entre elles et à la source de tension alternative par des sections d'un câble, et comportant un circuit de mesure, devant être branché entre une extrémité du conducteur du câble et un point de référence qui en est isolé, qui comprend en série une source de tension continue, une bobine d'arrêt et un générateur de valeur limite répondant au courant de mesure continu, caractérisé par le fait que la bobine d'arrêt (D) comporte un enroulement secondaire (D') qui alimente un circuit d'aimantation antagoniste comportant une résistance commandable (T1), de cette résistance commandable dépend du courant de circuit de mesure de manière que cette résistance diminue lorsque le courant augmente dans le circuit de mesure, et que le courant d'aimantation antagoniste comporte un élément redresseur (Gl1) qui est polarisé de manière que le courant qui circule dans le circuit d'aimantation antagoniste s'oppose à la pré-aimantation de la bobine d'arrêt (D) par le courant de mesure continu.

2. Dispositif de surveillance suivant la revendication 1, caractérisé par le fait que l'enroulement d'excitation du relais à courant continu (S1) se trouve dans le circuit de sortie d'un amplificateur auquel est appliqué côté entrée un signal proportionnel au courant dans le circuit de mesure.

3. Dispositif de surveillance suivant l'une des revendications 1 ou 2, comportant un instrument de mesure pour afficher le courant de défaut ou la résistance d'isolement dans le circuit de mesure, caractérisé par le fait que le circuit de mesure comporte une résistance supplémentaire (R7) qui est pontée par un contact de repos (S11) du relais à courant continu (S1), et que sur le générateur de valeur limite peut être branchée en parallèle une résistance (R11) qui est dimensionnée de manière que le générateur de valeur limite retombe lorsque la résistance est branchée en parallèle.

# FIG 1

2/2

FIG 2